# FASCICULE DE BREVET EUROPEEN

(11) **EP 3 903 342 B1**
(45) Date de publication et mention de la délivrance du brevet: **15.03.2023**
(21) Numéro de dépôt: 19850729.5
(22) Date de dépôt: 23.12.2019
(51) Int. Cl.: H01L 21/762, H01L 27/12, H01L 21/84, H01L 21/02

(54) **STRUCTURE DE TYPE SEMI-CONDUCTEUR POUR APPLICATIONS DIGITALES ET RADIOFRÉQUENCES, ET PROCÉDÉ DE FABRICATION D'UNE TELLE STRUCTURE**
HALBLEITERSTRUKTUR FÜR DIGITALE UND HOCHFREQUENTE ANWENDUNGEN UND VERFAHREN ZUR HERSTELLUNG EINER SOLCHEN STRUKTUR
SEMICONDUCTOR STRUCTURE FOR DIGITAL AND RADIOFREQUENCY APPLICATIONS, AND METHOD FOR MANUFACTURING SUCH A STRUCTURE

(30) Priorité: 24.12.2018 FR 1874130
(43) Date de publication de la demande: 03.11.2021
(73) Titulaire: SOITEC, 38190 Bernin (FR)
(72) Inventeur: MORANDINI, Yvan, 73110 La Trinité (FR); SCHWARZENBACH, Walter, 38330 Saint-Nazaire-les-Eymes (FR); ALLIBERT, Frédéric, 38100 Grenoble (FR); DESBONNETS, Eric, 38660 Lumbin (FR); NGUYEN, Bich-Yen, Austin, TEXAS 78733 (US)
(74) Mandataire: Regimbeau
(86) Numéro de dépôt international: PCT/FR2019/053279
(87) Numéro de publication internationale: WO 2020/136342

(56) Documents cités:
- US-A1- 2002 094 629
- US-A1- 2005 242 398
- US-A1- 2006 017 137
- US-A1- 2006 261 410
- US-A1- 2007 099 372
- US-A1- 2018 337 043
- US-B1- 9 824 891

## Description

### DOMAINE TECHNIQUE DE L'INVENTION

La présente invention concerne une structure de type semi-conducteur sur isolant pour des applications digitales et radiofréquences. L'invention se rapporte également à un procédé de fabrication d'une telle structure par transfert d'une couche d'un premier substrat, dit « substrat donneur », sur un deuxième substrat, dit « substrat receveur ».

### ETAT DE LA TECHNIQUE

Les structures de type semi-conducteur sur isolant sont des structures multicouches comprenant un substrat qui est généralement en silicium, une couche électriquement isolante agencée sur le substrat, qui est généralement une couche d'oxyde telle qu'une couche d'oxyde de silicium, et une couche semi-conductrice agencée sur la couche isolante dans laquelle sont réalisées la source et le drain de la structure, qui est généralement une couche de silicium.

De telles structures sont dites structure « Semiconductor on Insulator » (acronyme SeOI) en anglais, en particulier « Silicon on Insulator » (SOI) lorsque le matériau semi-conducteur est du silicium.

Parmi les structures SOI existantes, les structures dites « Fully-Depleted Silicon on Insulator » en anglais (acronyme FD-SOI) sont couramment utilisées pour des applications digitales. Les structures FD-SOI se caractérisent par la présence d'une couche mince d'oxyde, agencée sur un substrat support en silicium, et d'une couche semi-conductrice très mince agencée sur la couche d'oxyde, dite couche SOI.

La couche d'oxyde se trouve entre le substrat et la couche SOI. La couche d'oxyde est alors dite « enterrée », et est appelée « BOX » pour « Buried OXide » en anglais.

La couche SOI permet d'implémenter le canal de conduction de la structure FD-SOI.

Du fait de la faible épaisseur et de l'uniformité de la couche de BOX et de la couche SOI, il n'est pas nécessaire de doper le canal de conduction, d'où le fait que la structure puisse fonctionner selon un mode totalement déplété.

Les structures FD-SOI présentent des caractéristiques électrostatiques améliorées par rapport aux structures sans couche de BOX. La couche de BOX diminue la capacité électrique parasite entre la source et le drain, et permet également de réduire considérablement les fuites d'électrons depuis le canal de conduction vers le substrat en confinant le flux d'électrons dans le canal de conduction, réduisant ainsi les pertes de courant électrique et améliorant les performances de la structure.

Les structures FD-SOI peuvent être compatibles avec des applications radiofréquences (RF), mais pâtissent cependant de l'apparition de pertes électriques dans ledit substrat.

Pour pallier ces pertes électriques et améliorer les performances RF, il est connu d'utiliser un substrat, notamment de type SOI, présentant une haute résistivité électrique, ce type de substrat étant communément appelé « substrat HR » pour substrat à haute résistivité. Ce dernier est avantageusement combiné avec une couche de piégeage de charges (« trap-rich layer » en anglais). Cependant, ce type de substrat, n'est pas compatible avec une utilisation de transistors dont la tension de seuil peut être contrôlée par une grille en face arrière (« back bias voltage » en anglais »).

En effet, la présence de cette couche comportant des charges piégées gêne la polarisation en face arrière (application d'une différence de potentiel au niveau de la face arrière) et peut en outre conduire à une diffusion accélérée des dopants empêchant ainsi la réalisation de jonction PN de bonne qualité, à cause des problèmes de fuite de jonction.

Outre les structures FD-SOI comprenant une couche de BOX, des structures FD-SOI à deux couches de BOX, dites « double BOX » ont été réalisées.

La technologie à deux couches BOX est avantageuse dans le cas où la structure FD-SOI comprend des transistors à double grille dont les électrodes de grille sont formées à la fois au-dessus et en-dessous du canal de conduction. Ainsi, la couche SOI de la grille arrière, dite « back gate SOI layer », est séparée électriquement de la couche SOI de la grille avant, dite « front gate SOI layer », par une première couche de BOX, et est séparée électriquement également du substrat de base par une deuxième couche de BOX.

Le document US 2010/0176482 décrit un exemple d'une telle structure FD-SOI à deux couches de BOX, pour une technologie CMOS.

Selon ce document, des structures CMOS avec un matériau de grille à haute constante diélectrique (« high-k material ») et avec une longueur de grille réduite jusqu'à 30 nm sont fabriquées selon un procédé optimisé permettant d'obtenir une bonne isolation entre les dispositifs et la grille arrière.

La technologie double BOX existante est utilisée pour des applications digitales, et non à la fois pour des applications radiofréquence et digitale.

Par ailleurs, la tenue en puissance maximale des structures FD-SOI à double BOX est limitée avec des couches de BOX d'épaisseur standard. Ceci pose un problème pour des applications radiofréquences.

En effet, pour augmenter la tenue en puissance de certains composants radiofréquences, tels que les amplificateurs de puissance et les interrupteurs d'antenne, il est nécessaire d'empiler des transistors MOSFETS (acronyme anglais de Metal Oxide Semiconductor Field Effect Transistor - qui se traduit par transistor à effet de champ à structure métal-oxyde-semiconducteur) afin de s'assurer que la tension électrique entre le drain et la source est inférieure à la tension de fonctionnement maximale autorisée.

Cependant, la tension maximale entre le drain et le substrat support et la tension maximale entre la source et le substrat support sont limitées par la tension de claquage de la couche de BOX. Avec une épaisseur standard de la couche de BOX de 20 nm, la tension de claquage n'est que de 25 V (ce qui conduit à concevoir des dispositifs avec une tension maximale bien plus faible, allant de 10 à 15V), ce qui représente une limitation importante.

Le document US 2005/242398 A1 se rapporte à une structure de type SOI comprenant des zones FD-SOI et RF-SOI formées dans la même couche active semi-conductrice.

Ainsi, la technologie double BOX existante pour les applications digitales n'est pas compatible avec les applications radiofréquences.

### BREVE DESCRIPTION DE L'INVENTION

Un but de l'invention est de proposer une structure de type semi-conducteur sur isolant permettant de surmonter les inconvénients mentionnés précédemment. L'invention vise à proposer une telle structure permettant de combiner des applications digitales et des applications radiofréquences.

A cette fin, l'invention propose une structure de type semi-conducteur sur isolant comprenant successivement depuis une face arrière vers une face avant de la structure :
- un substrat support semi-conducteur à haute résistivité électrique, dont la résistivité électrique est comprise entre 500 Ω.cm et 30 kΩ.cm,
- une première couche électriquement isolante,
- une couche intercalaire,
- une deuxième couche électriquement isolante, qui présente une épaisseur inférieure à celle de la première couche électriquement isolante,
- une couche active semi-conductrice,
- au moins une région de type FD-SOI, dans laquelle la couche intercalaire est une couche semi-conductrice,
- au moins une région de type RF-SOI, adjacente à la région de type FD-SOI, dans laquelle la couche intercalaire est une troisième couche électriquement isolante, ladite région de type RF-SOI comprenant au moins un composant radiofréquence à l'aplomb de la troisième couche isolante.

Selon d'autres aspects, la structure proposée présente les différentes caractéristiques suivantes prises seules ou selon leurs combinaisons techniquement possibles :
- la somme des épaisseurs de la première couche électriquement isolante, de la deuxième couche électriquement isolante, et de la troisième couche électriquement isolante est comprise entre 50 nm et 1500 nm ;
- la structure comprend en outre une couche de piégeage de charges agencée entre le substrat support et la première couche électriquement isolante ;
- la couche de piégeage de charges est en silicium polycristallin ou en silicium poreux ;
- la couche intercalaire semi-conductrice est en matériau cristallin ou polycristallin ;
- la couche intercalaire semi-conductrice est en matériau amorphe ;
- la première couche électriquement isolante est une couche d'oxyde de silicium ;
- la deuxième couche électriquement isolante est une couche d'oxyde de silicium ;
- la troisième couche électriquement isolante est une couche d'oxyde de silicium ;
- la première couche électriquement isolante présente une épaisseur comprise entre 20 nm et 1000 nm ;
- la deuxième couche électriquement isolante présente une épaisseur comprise entre 10 nm et 100 nm ;
- la couche active semi-conductrice présente une épaisseur comprise entre 3 nm et 30 nm.

L'invention se rapporte aussi à un procédé de fabrication d'une structure multicouche de type semi-conducteur sur isolant, comprenant les étapes suivantes :
- fourniture d'un premier substrat donneur,
- formation d'une zone de fragilisation dans ledit premier substrat donneur, de sorte à délimiter une première couche intercalaire semi-conductrice,
- transfert de ladite première couche intercalaire semi-conductrice sur un substrat support semi-conducteur, une première couche électriquement isolante étant à l'interface entre le substrat donneur et le substrat support de sorte à former une structure intermédiaire comprenant le substrat support, la première couche électriquement isolante, et la première couche intercalaire semi-conductrice transférée,
- retrait local d'une portion de la première couche intercalaire semi-conductrice jusqu'à la première couche électriquement isolante pour former une cavité,
- dépôt d'une couche électriquement isolante, dite troisième couche électriquement isolante, dans la cavité,
- fourniture d'un second substrat donneur,
- formation d'une zone de fragilisation dans ledit second substrat donneur, de sorte à délimiter une deuxième couche active semi-conductrice,
- transfert de ladite deuxième couche active semi-conductrice sur la structure intermédiaire, une deuxième couche électriquement isolante étant à l'interface entre le second substrat donneur et la structure intermédiaire et qui présente une épaisseur inférieure à celle de la première couche électriquement isolante,
- réalisation :
   - d'au moins un composant digital dans la deuxième couche active semi-conductrice à l'aplomb de la première couche intercalaire semi-conductrice, pour former une région de type FD-SOI, et
   - d'au moins un composant radiofréquence à l'aplomb de la troisième couche électriquement isolante, pour former une région de type RF-SOI.

L'invention se rapporte également à un procédé de fabrication d'une structure multicouche de type semi-conducteur sur isolant, comprenant les étapes suivantes :
- formation d'une structure intermédiaire par dépôt d'une première couche intercalaire semi-conductrice sur un substrat support recouvert d'une première couche électriquement isolante,
- retrait local d'une portion de la première couche intercalaire semi-conductrice jusqu'à la première couche électriquement isolante pour former une cavité,
- dépôt d'une couche électriquement isolante, dite troisième couche électriquement isolante, dans la cavité,
- fourniture d'un substrat donneur,
- formation d'une zone de fragilisation dans ledit substrat donneur, de sorte à délimiter une deuxième couche active semi-conductrice,
- transfert de ladite deuxième couche active semi-conductrice sur la structure intermédiaire, une deuxième couche électriquement isolante étant à l'interface entre le substrat donneur et la structure intermédiaire et qui présente une épaisseur inférieure à celle de la première couche électriquement isolante,
- réalisation :
   - d'au moins un composant digital dans la deuxième couche active semi-conductrice à l'aplomb de la première couche intercalaire semi-conductrice, pour former une région de type FD-SOI, et
   - d'au moins un composant radiofréquence à l'aplomb de la troisième couche électriquement isolante, pour former une région de type RF-SOI.

Selon d'autres aspects, les procédés proposés présentent les différentes caractéristiques suivantes prises seules ou selon leurs combinaisons techniquement possibles :
- le composant radiofréquence est réalisé dans la deuxième couche active semi-conductrice ;
- le retrait local d'une portion de la première couche intercalaire semi-conductrice et le dépôt d'une troisième couche électriquement isolante dans la cavité sont réalisées après le transfert de la deuxième couche semi-conductrice sur la structure intermédiaire ;
- le procédé comprend en outre la formation d'une couche de piégeage de charges sur le substrat support, ladite couche de piégeage de charges étant agencée entre le substrat support et la première couche électriquement isolante ;
- le retrait local comprend le dépôt d'un masque par lithographie et la gravure de la première couche intercalaire semi-conductrice au travers d'au moins une ouverture dudit masque ;
- le procédé comprend en outre, avant le transfert de ladite deuxième couche semi-conductrice sur la structure intermédiaire, un traitement des surfaces libres de la première couche intercalaire semi-conductrice et de la troisième couche électriquement isolante pour en réduire la rugosité.

La structure multicouche de l'invention sert de support à la fabrication de transistors, en particulier des transistors à effet de champ de type MOSFET (« Metal Oxyde Semiconductor Field Effect Transistor » en anglais). Les transistors MOFSET sont des dispositifs semi-conducteurs à trois électrodes actives, dont une électrode d'entrée appelée grille, une électrode de sortie appelée drain, et une troisième électrode appelée source. Ces transistors permettent de contrôler une tension (ou un courant) de sortie sur le drain grâce à la grille.

Dans le présent texte, le terme « sur », qui se rapporte à la position d'une première couche par rapport à une deuxième couche, ou à la position d'un composant par rapport à une couche, n'implique pas nécessairement que la première couche soit directement au contact de la deuxième ou que le composant soit directement au contact de la couche. Sauf mention contraire, ce terme n'exclut pas qu'une ou plusieurs autres couches soient intercalées entre la première couche et la deuxième couche, ou entre le composant et la couche.

Les termes « à l'aplomb de » qui se rapportent à la position d'un composant par rapport à une couche au sein d'une structure, signifient que le composant et la couche se font face dans le sens de l'épaisseur de la structure. En d'autres termes, tout axe qui s'étend selon l'épaisseur de la structure et qui intercepte le composant, intercepte également la couche à l'aplomb de ce composant.

### DESCRIPTION DES FIGURES

D'autres avantages et caractéristiques de l'invention apparaîtront à la lecture de la description suivante donnée à titre d'exemple illustratif et non limitatif, en référence aux figures annexées suivantes :
La figure 1 est un schéma d'un mode de réalisation d'une structure multicouche selon l'invention, comprenant deux régions de type FD-SOI et une région de type RF-SOI ;
La figure 2 est un schéma d'une des régions de type FD-SOI de la structure illustrée sur la figure 1 ;
La figure 3 est un schéma de la région de type RF-SOI de la structure illustrée sur la figure 1 ;
La figure 4 est un schéma d'une structure intermédiaire, comprenant une première couche intercalaire semi-conductrice sur un substrat support recouvert préalablement d'une première couche électriquement isolante ;
La figure 5 est un schéma de la structure intermédiaire de la figure 4, dans laquelle est réalisée une cavité ;
La figure 6 est un schéma de la structure intermédiaire de la figure 5, dans laquelle la cavité est comblée par une couche électriquement isolante ;
La figure 7 est un schéma d'une structure multicouche ;
La figure 8 est un schéma de la structure multicouche de la figure 7, dans laquelle est réalisée une tranchée ;
La figure 9 est un schéma de la structure multicouche de la figure 8, dans laquelle est réalisée une cavité latérale ;
La figure 10 est un schéma de la structure multicouche de la figure 9, dans laquelle la cavité est comblée par une couche électriquement isolante.

### DESCRIPTION DETAILLEE DE MODES DE REALISATION DE L'INVENTION

Un premier objet de l'invention concerne une structure multicouche de type semi-conducteur sur isolant, utilisable à la fois pour des applications digitales et pour des applications radiofréquences.

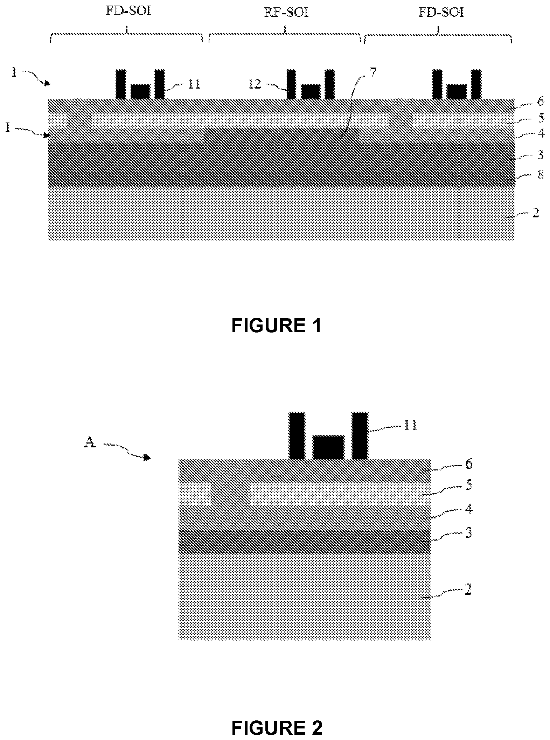

La figure 1 illustre un mode de réalisation d'une telle structure multicouche 1 selon l'invention.

En référence à la figure 1, la structure multicouche 1 comprend successivement, depuis une face arrière vers une face avant de la structure, un substrat support semi-conducteur 2, une première couche électriquement isolante 3, une couche intercalaire I, une deuxième couche électriquement isolante 5, et une couche active 6 semi-conductrice.

Le substrat support semi-conducteur 2 est un substrat hautement résistif, c'est-à-dire qu'il présente une résistivité électrique comprise entre 500 Ω.cm et 30 kΩ.cm, et de préférence comprise entre 1 kΩ.cm et 10 kΩ.cm. Une résistivité élevée confère au substrat support la capacité de limiter les pertes électriques et d'améliorer les performances radiofréquences de la structure.

La première couche électriquement isolante 3 permet d'isoler le substrat support 2 de la couche intercalaire I et des couches sus-jacentes à ladite couche intercalaire.

La première couche électriquement isolante 3 est de préférence une couche d'oxyde. Cette couche étant enterrée dans la structure entre le substrat support et la couche intercalaire, elle peut également être appelée « premier BOX ». Il s'agit de préférence d'une couche d'oxyde de silicium.

L'épaisseur de la première couche électriquement isolante 3 est relativement élevée, et de préférence comprise entre 20 nm (nanomètres) et 1000 nm. Une épaisseur trop faible, en particulier inférieure à 20 nm, risque en effet d'aboutir à un claquage de la première couche électriquement isolante. En particulier, la première couche électriquement isolante 3 présente de préférence une épaisseur supérieure à celle de la couche active semi-conductrice 6.

Optionnellement, la structure 1 comprend également une couche de piégeage de charges 8, préférentiellement en silicium polycristallin ou en silicium poreux agencée entre le substrat support 2 et la première couche électriquement isolante 3. Cette couche de piégeage de charges permet de piéger les charges électriques qui s'accumulent sous la première couche électriquement isolante 3.

La deuxième couche électriquement isolante 5 permet d'isoler la couche active semi-conductrice 6 de la couche intercalaire I et des couches sous-jacentes à la couche intercalaire.

La deuxième couche électriquement isolante 5 est de préférence une couche d'oxyde, de préférence une couche d'oxyde de silicium. Cette couche étant enterrée dans la structure entre la couche intercalaire et la couche active semi-conductrice, elle peut être appelée « deuxième BOX ».

La deuxième couche électriquement isolante 5 présente une épaisseur relativement faible, et inférieure à celle de la première couche électriquement isolante 3. Cette faible épaisseur permet de pouvoir assurer un contrôle de la tension de seuil (« back bias voltage » en anglais ») du transistor par une polarisation adaptée de la couche intercalaire sous-jacente. Une épaisseur de la deuxième couche électriquement isolante 5 de préférence comprise entre 10 nm et 100 nm est adaptée à cet effet.

La couche active semi-conductrice 6 est destinée à la réalisation à la fois de composants digitaux 11 et éventuellement de composants radiofréquences 12, ceux-ci étant fonction des applications digitales et radiofréquences souhaitées pour la structure.

La couche active semi-conductrice 6 est de préférence une couche de silicium monocristallin.

L'épaisseur de la couche active semi-conductrice 6 est de préférence comprise entre 3 nm et 30 nm, et de manière davantage préférée entre 5 nm et 20 nm. On préfèrera que l'épaisseur de la couche active semi-conductrice soit homogène sur l'ensemble du matériau, c'est-à-dire qu'elle présente une variation d'épaisseur inférieure ou égale à 1 nm, afin d'optimiser le fonctionnement des régions FD-SOI, selon un mode totalement déplété. Les régions FD-SOI sont détaillées dans la suite du présent texte.

La structure multicouche 1 comprend plusieurs régions destinées à des applications différentes, dont au moins une région de type FD-SOI pour des applications digitales et au moins une région de type RF-SOI pour des applications radiofréquences.

Afin de pouvoir combiner une région de type FD-SOI et une région de type RF-SOI dans une seule et même structure, la couche intercalaire I est agencée entre la première et la deuxième couche électriquement isolante 3, 5, et la nature de cette couche intercalaire I est différente selon qu'elle se trouve dans une région de type FD-SOI ou dans une région de type RF-SOI.

Une des deux régions de type FD-SOI de la structure de la figure 1 est représentée sur la figure 2.

Dans une région de type FD-SOI, la couche intercalaire I est une couche semi-conductrice 4.

La couche intercalaire semi-conductrice 4 est avantageusement en matériau cristallin ou en matériau amorphe, éventuellement dopé. Ce matériau est choisi pour que la couche semi-conductrice puisse être polarisée pour contrôler la tension de seuil du transistor.

Le matériau de la couche intercalaire semi-conductrice 4 est avantageusement une couche semi-conductrice de préférence choisi parmi : le silicium monocristallin, le silicium polycristallin, et l'alliage de Si et de Ge.

La région de type FD-SOI comprend au moins un composant digital 11 dans la couche active semi-conductrice 6. Sur la figure 1, le composant digital est ainsi positionné à l'aplomb de la couche semi-conductrice.

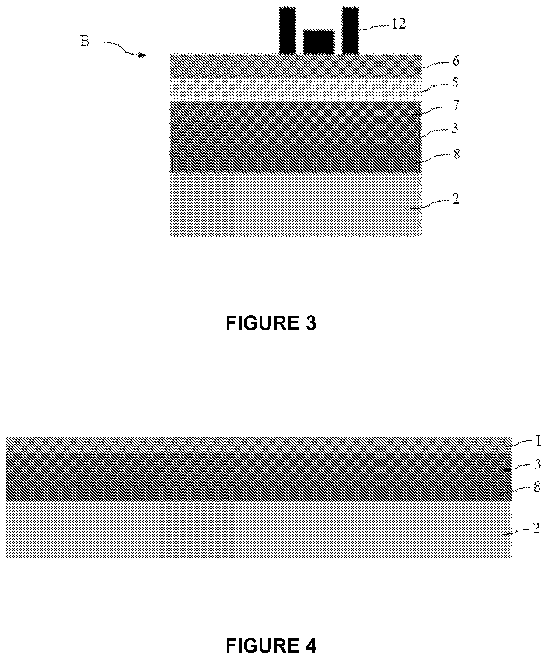

La région de type RF-SOI de la structure de la figure 1 est représentée sur la figure 3.

Dans une région de type RF-SOI, la couche intercalaire I est une couche électriquement isolante 7, appelée troisième couche électriquement isolante.

La troisième couche électriquement isolante 7 permet d'isoler davantage la couche active semi-conductrice 6 du substrat support 2, c'est-à-dire d'isoler électriquement la grille avant de la grille arrière du transistor.

La troisième couche électriquement isolante 7 est de préférence une couche d'oxyde. Cette couche étant enterrée dans la structure entre la première et la deuxième couche électriquement isolante, elle peut être appelée « troisième BOX ». Il s'agit de préférence d'une couche d'oxyde de silicium.

La région de type RF-SOI comprend au moins un composant radiofréquence 12 à l'aplomb de la troisième couche électriquement isolante 7, en particulier dans la couche active semi-conductrice 6. Le composant radiofréquence 12 peut également être formé dans l'une des couches électriquement isolantes 5, 7 ou 3, préférentiellement sur la couche électriquement isolante 5, pour bénéficier de l'effet d'un BOX composé des trois couches électriquement isolantes 5, 7 et 3. Sur la figure 3, le composant radiofréquence est ainsi positionné à l'aplomb de la troisième couche électriquement isolante.

Selon un mode de réalisation préférée, la somme des épaisseurs de la première couche électriquement isolante 3, de la deuxième couche électriquement isolante 5, et de la troisième couche électriquement isolante 7 est comprise entre 50 nm et 1500 nm. L'épaisseur de chacune des trois couches électriquement isolantes est donc ajustée pour obtenir l'épaisseur totale décrite. Une telle épaisseur permet d'optimiser la tension de claquage pour les composants radiofréquences.

Un procédé de fabrication d'une structure multicouche 1 telle que décrite précédemment va maintenant être décrit selon trois modes de réalisation.

Selon un premier mode de réalisation, on fournit initialement un premier substrat donneur.

On forme dans ce substrat une zone de fragilisation, de manière à délimiter une première couche intercalaire semi-conductrice. La zone de fragilisation est formée dans le substrat donneur à une profondeur prédéterminée qui correspond sensiblement à l'épaisseur de la couche semi-conductrice à transférer. De préférence, la zone de fragilisation est créée par implantation d'atomes d'hydrogène et/ou d'hélium dans le substrat donneur.

On transfère ensuite la première couche intercalaire semi-conductrice sur un substrat support semi-conducteur, qui est un substrat receveur, en collant le substrat donneur sur le substrat support par l'intermédiaire de la première couche électriquement isolante puis en détachant le substrat donneur le long de la zone de fragilisation (procédé Smart Cut^{™}).

De manière alternative, le transfert peut être réalisé en amincissant le substrat donneur par sa face opposée à la face collée sur le substrat support, jusqu'à l'obtention de l'épaisseur souhaitée pour la première couche intercalaire semi-conductrice.

Optionnellement, avant l'étape de collage, on forme une couche de piégeage de charges sur le substrat support, entre le substrat support et la première couche électriquement isolante.

On obtient alors, comme l'illustre la figure 4, une structure intermédiaire comprenant le substrat support 2, la couche de piégeage de charges 8 lorsque présente, la première couche électriquement isolante 3, et la première couche intercalaire semi-conductrice transférée I.

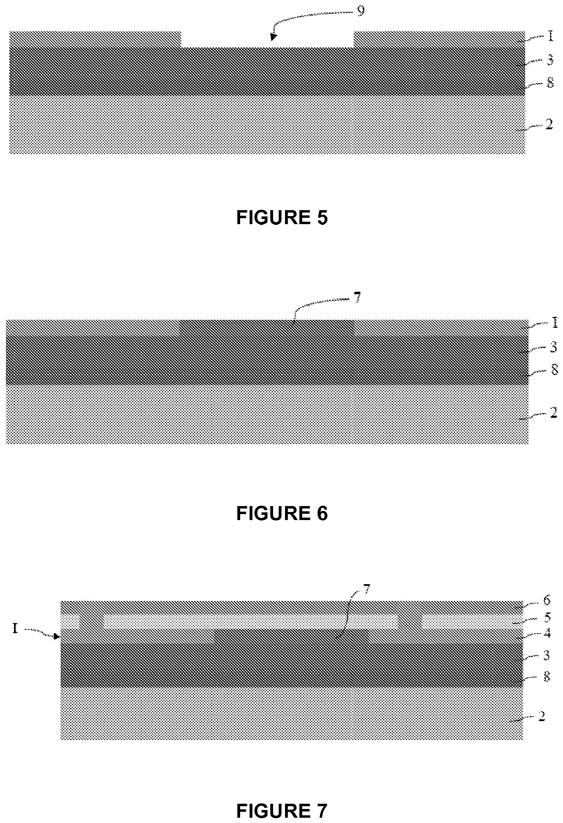

En référence à la figure 5, on procède ensuite à un retrait local d'une portion de la première couche intercalaire semi-conductrice jusqu'à la première couche électriquement isolante pour former une cavité 9. Sur la figure 5, la cavité 9 est délimitée dans l'épaisseur de la structure par la première couche électriquement isolante 3, et latéralement par deux portions de la première couche intercalaire semi-conductrice 4.

Le retrait local peut avantageusement être réalisé par gravure. A cet effet, un masque de lithographie est déposé sur la première couche intercalaire semi-conductrice 4. Le masque est pourvu d'au moins une ouverture. La première couche intercalaire semi-conductrice est ensuite gravée au travers de l'ouverture du masque afin de former la cavité 9. Toute technique de gravure connue convenant à cet effet est utilisable, comme par exemple une gravure sèche.

En référence à la figure 6, on dépose ensuite la troisième couche électriquement isolante 7 dans la cavité 9, afin de remplir la cavité. Après dépôt, la surface supérieure de la troisième couche électriquement isolante affleure la surface supérieure de la couche semi-conductrice.

Par ailleurs, on fournit un second substrat donneur.

On forme dans ce substrat une zone de fragilisation, de manière à délimiter une deuxième couche semi-conductrice 6. La zone de fragilisation peut être formée de la même manière que pour délimiter la première couche intercalaire semi-conductrice.

On transfère ensuite la deuxième couche semi-conductrice 6 sur la structure intermédiaire, en collant le second substrat donneur sur la structure intermédiaire par l'intermédiaire de la deuxième couche électriquement isolante 5 (formée soit sur la structure intermédiaire soit sur ledit substrat donneur) puis en détachant le substrat donneur le long de la zone de fragilisation (procédé Smart Cut^{™}).

De manière alternative, le transfert peut être réalisé en amincissant le second substrat donneur par sa face opposée à la face collée sur la structure intermédiaire, jusqu'à l'obtention de l'épaisseur souhaitée pour la deuxième couche semi-conductrice 6.

De manière optionnelle, avant l'étape de transfert, on peut procéder à un traitement des surfaces libres de la première couche intercalaire semi-conductrice et de la troisième couche électriquement isolante, afin d'en réduire la rugosité. Ce traitement de surface améliore le collage de la deuxième couche électriquement isolante sur la première couche intercalaire semi-conductrice et de la troisième couche électriquement isolante.

On réalise ensuite un ou plusieurs composants digitaux 11 sur la deuxième couche semi-conductrice 6, qui est la couche active semi-conductrice. Les composants digitaux sont réalisés à l'aplomb de la première couche intercalaire semi-conductrice, c'est-à-dire en face de la première couche intercalaire semi-conductrice dans le sens de l'épaisseur de la structure. Ceci permet d'obtenir une région de type FD-SOI.

On réalise également un ou plusieurs composants radiofréquences 12 sur la couche active semi-conductrice, à l'aplomb de la troisième couche électriquement isolante 7. Ceci permet d'obtenir une région de type RF-SOI.

Le premier mode de réalisation qui vient d'être décrit comprend deux étapes de délimitation et de transfert d'une couche semi-conductrice. Ceci est tout particulièrement avantageux dans le cas où la première couche intercalaire semi-conductrice est cristalline. Le transfert d'une telle couche depuis un substrat donneur permet de conserver sa qualité cristalline sur la structure finale.

Lorsqu'une optimisation de la qualité cristalline de la première couche intercalaire semi-conductrice n'est pas requise, par exemple lorsque celle-ci est amorphe, il est possible de former la première intercalaire couche semi-conductrice par dépôt sur la première couche électriquement isolante. Ce procédé ne met donc en jeu qu'une seule étape de transfert, c'est-à-dire celui de la couche active semi-conductrice, et est donc plus économique.

Ce procédé correspond à un deuxième mode de réalisation qui va maintenant être décrit.

Selon un deuxième mode de réalisation, on forme une structure intermédiaire, comme l'illustre la figure 4, en déposant une première couche intercalaire semi-conductrice 4 sur un substrat support 2 recouvert préalablement d'une première couche électriquement isolante 3.

La première couche intercalaire semi-conductrice 4 peut être formée par épitaxie sur le substrat support recouvert d'une première couche électriquement isolante, ou alternativement déposée sur ledit substrat support notamment par dépôt chimique en phase vapeur, communément appelé selon la terminologie anglaise « Chemical Vapor Déposition » et désigné sous l'acronyme CVD.

Optionnellement, avant le dépôt de la première couche intercalaire semi-conductrice, on forme une couche de piégeage de charges 8 sur le substrat support 2, entre le substrat support et la première couche électriquement isolante 3.

En référence à la figure 5, on procède ensuite à un retrait local d'une portion de la première couche intercalaire semi-conductrice 4 jusqu'à la première couche électriquement isolante 3 pour former une cavité 9. Sur la figure 5, la cavité 9 est délimitée dans l'épaisseur de la structure par la première couche électriquement isolante 3, et latéralement par deux portions de la première couche intercalaire semi-conductrice 4.

Le retrait local peut avantageusement être réalisé par gravure, de manière similaire au premier mode de réalisation.

En référence à la figure 6, on dépose ensuite une couche électriquement isolante 5, dite troisième couche électriquement isolante, dans la cavité 9, afin de remplir la cavité. Après dépôt, la surface supérieure de la troisième couche électriquement isolante 7 affleure la surface supérieure de la couche intercalaire semi-conductrice 4.

Par ailleurs, on fournit un substrat donneur.

On forme dans ce substrat une zone de fragilisation, de manière à délimiter une deuxième couche semi-conductrice 6. La zone de fragilisation peut être formée de la même manière que pour le premier mode de réalisation.

On transfère ensuite la deuxième couche semi-conductrice 6 sur la structure intermédiaire, en collant le substrat donneur sur la structure intermédiaire par l'intermédiaire de la deuxième couche électriquement isolante 5 puis en détachant le substrat donneur le long de la zone de fragilisation (procédé Smart Cut^{™}).

De manière alternative, le transfert peut être réalisé en amincissant le substrat donneur par sa face opposée à la face collée sur la structure intermédiaire, jusqu'à l'obtention de l'épaisseur souhaitée pour la deuxième couche semi-conductrice 6.

De manière optionnelle, avant l'étape de transfert, on peut procéder à un traitement des surfaces libres de la première couche intercalaire semi-conductrice 4 et de la troisième couche électriquement isolante 7, afin d'en réduire la rugosité. Ce traitement de surface améliore le collage de la deuxième couche électriquement isolante sur la première couche intercalaire semi-conductrice et de la troisième couche électriquement isolante.

On réalise ensuite un ou plusieurs composants digitaux 11 sur la deuxième couche semi-conductrice 6, qui est la couche active semi-conductrice. Les composants digitaux 11 sont réalisés à l'aplomb de la première couche intercalaire semi-conductrice 4. Ceci permet d'obtenir une région de type FD-SOI.

On réalise également un ou plusieurs composants radiofréquences 12 sur la couche active semi-conductrice, à l'aplomb de la troisième couche électriquement isolante 7. Ceci permet d'obtenir une région de type RF-SOI.

Selon un troisième mode de réalisation, le procédé de fabrication comprend les mêmes étapes que celles du premier mode de réalisation ou celles du deuxième mode de réalisation. Cependant, contrairement à ces derniers où le retrait local d'une portion de la première couche intercalaire semi-conductrice 4 et le dépôt de la troisième couche électriquement isolante 7 dans la cavité 9 sont réalisées avant le transfert de la deuxième couche semi-conductrice 6 sur la structure intermédiaire, les étapes de retrait et de dépôt sont réalisées après l'étape de transfert.

En particulier, les étapes de retrait et de dépôt selon le troisième mode de réalisation sont réalisées sur une structure dans laquelle une troisième couche électriquement isolante 7 a été préalablement formée selon le premier ou le deuxième mode de réalisation décrit précédemment.

Les étapes de retrait et de dépôt de la troisième couche électriquement isolante 7 peuvent être réalisées avant la réalisation des composants digitaux 11 et radiofréquences 12, ou bien après la réalisation des composants digitaux et radiofréquences c'est-à-dire pendant la fabrication du transistor. Il peut s'agir notamment d'un transistor de type MOS tel qu'un CMOS.

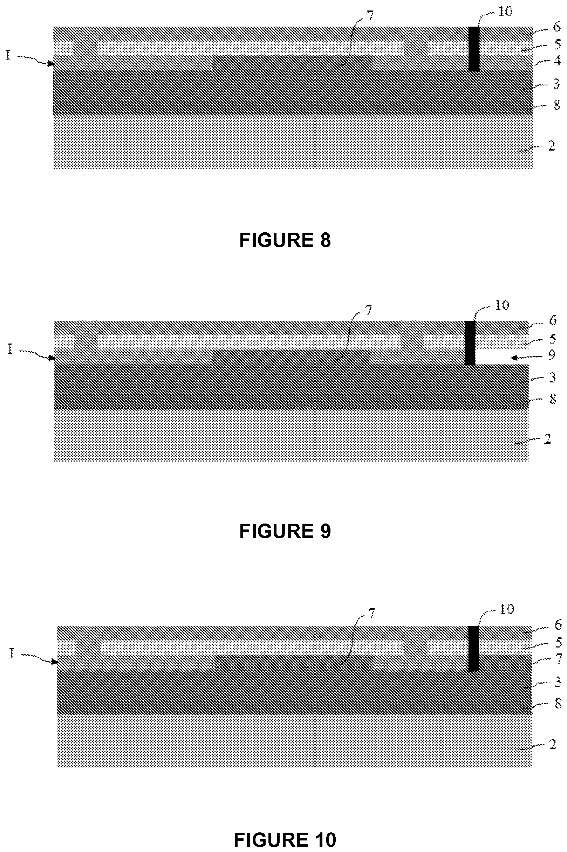

Selon ce troisième mode de réalisation, en référence aux figures 7 et 8, on creuse une tranchée 10 à une distance déterminée du bord de la structure, de sorte que la tranchée s'étend depuis la surface libre de la couche active semi-conductrice 6, à travers la deuxième couche électriquement isolante 5 et la première couche intercalaire semi-conductrice 4, jusqu'au moins la première couche électriquement isolante 3. Ceci permet d'isoler physiquement la portion latérale délimitée par la tranchée 10 du reste de la structure.

En référence à la figure 9, on procède ensuite à un retrait local de la première couche intercalaire semi-conductrice 4 dans la portion latérale, afin de former une cavité 9.

Comme le montre la figure 9, ladite cavité 9 est une cavité latérale, située en bord de zone utile, et est ouverte sur l'extérieur de la structure. Elle est délimitée dans l'épaisseur de la structure par la première couche électriquement isolante 3 et la deuxième couche électriquement isolante 5, et latéralement par la ou les tranchée(s) 10.

En référence à la figure 10, on dépose ensuite la troisième couche électriquement isolante 7 dans la cavité 9, afin de remplir la cavité.

On peut ensuite réaliser un ou plusieurs composants radiofréquences 12 sur la couche active semi-conductrice 6, à l'aplomb de la troisième couche électriquement isolante 7. On obtient alors une région de type RF-SOI en bord de structure.

L'avantage de réaliser la troisième couche électriquement isolante durant le procédé de fabrication du transistor permet d'utiliser les masques de gravure de ce procédé, et donc de bénéficier d'un alignement optimal des différentes couches de la structure.

## Revendications

1. Structure multicouche (1) de type semi-conducteur sur isolant, comprenant successivement depuis une face arrière vers une face avant de la structure :
- un substrat support semi-conducteur (2) présentant une résistivité électrique comprise entre 500 Ω.cm et 30 kΩ.cm,
- une première couche électriquement isolante (3),
- une couche intercalaire (I),
- une deuxième couche électriquement isolante (5), qui présente une épaisseur inférieure à celle de la première couche électriquement isolante (3),
- une couche active (6) semi-conductrice,
- au moins une région de type FD-SOI, dans laquelle la couche intercalaire (I) est une couche semi-conductrice (4),
- au moins une région de type RF-SOI, adjacente à la région de type FD-SOI, dans laquelle la couche intercalaire (I) est une troisième couche électriquement isolante (7), ladite région de type RF-SOI comprenant au moins un composant radiofréquence à l'aplomb de la troisième couche électriquement isolante (7).

2. Structure (1) selon la revendication 1, dans laquelle la somme des épaisseurs de la première couche électriquement isolante (3), de la deuxième couche électriquement isolante (5), et de la troisième couche électriquement isolante (7) est comprise entre 50 nm et 1500 nm.

3. Structure (1) selon la revendication 1 ou la revendication 2, comprenant en outre une couche de piégeage de charges (8) agencée entre le substrat support (2) et la première couche électriquement isolante (3).

4. Structure (1) selon la revendication 3, dans laquelle la couche de piégeage de charges (8) est en silicium polycristallin ou en silicium poreux.

5. Structure (1) selon l'une des revendications 1 à 4, dans laquelle la couche intercalaire (4) semi-conductrice est en matériau cristallin ou polycristallin ou en matériau amorphe.

6. Structure (1) selon l'une des revendications précédentes, dans laquelle l'une au moins de la première couche électriquement isolante (3), la deuxième couche électriquement isolante (5) et la troisième couche électriquement isolante (7) est une couche d'oxyde de silicium.

7. Structure (1) selon l'une des revendications précédentes, dans laquelle la première couche électriquement isolante (3) présente une épaisseur comprise entre 20 nm et 1000 nm.

8. Structure (1) selon l'une des revendications précédentes, dans laquelle la deuxième couche électriquement isolante (5) présente une épaisseur comprise entre 10 nm et 100 nm.

9. Structure (1) selon l'une des revendications précédentes, dans laquelle la couche active (6) semi-conductrice présente une épaisseur comprise entre 3 nm et 30 nm.

10. Procédé de fabrication d'une structure multicouche (1) de type semi-conducteur sur isolant, comprenant les étapes suivantes :
- fourniture d'un premier substrat donneur,
- formation d'une zone de fragilisation dans ledit premier substrat donneur, de sorte à délimiter une première couche intercalaire semi-conductrice (4),
- transfert de ladite première couche intercalaire semi-conductrice (4) sur un substrat support semi-conducteur (2), une première couche électriquement isolante (3) étant à l'interface entre le substrat donneur et le substrat support (2) de sorte à former une structure intermédiaire comprenant le substrat support (2), la première couche électriquement isolante (3), et la première couche intercalaire semi-conductrice (4) transférée,
- retrait local d'une portion de la première couche intercalaire semi-conductrice (4) jusqu'à la première couche électriquement isolante (3) pour former une cavité,
- dépôt d'une couche électriquement isolante, dite troisième couche électriquement isolante (7), dans la cavité,
- fourniture d'un second substrat donneur,
- formation d'une zone de fragilisation dans ledit second substrat donneur, de sorte à délimiter une deuxième couche active semi-conductrice (6),
- transfert de ladite deuxième couche active semi-conductrice (6) sur la structure intermédiaire, une deuxième couche électriquement isolante (5) étant à l'interface entre le second substrat donneur et la structure intermédiaire et qui présente une épaisseur inférieure à celle de la première couche électriquement isolante,
- réalisation :
d'au moins un composant digital (11) dans la deuxième couche active semi-conductrice (6) à l'aplomb de la première couche intercalaire semi-conductrice (4), pour former une région de type FD-SOI, et
d'au moins un composant radiofréquence (12) à l'aplomb de la troisième couche électriquement isolante (7), pour former une région de type RF-SOI.

11. Procédé de fabrication d'une structure multicouche (1) de type semi-conducteur sur isolant, comprenant les étapes suivantes :
- formation d'une structure intermédiaire par dépôt d'une première couche intercalaire semi-conductrice (4) sur un substrat support (2) recouvert d'une première couche électriquement isolante (3),
- retrait local d'une portion de la première couche intercalaire semi-conductrice (4) jusqu'à la première couche électriquement isolante (3) pour former une cavité,
- dépôt d'une couche électriquement isolante, dite troisième couche électriquement isolante (7), dans la cavité,
- fourniture d'un substrat donneur,
- formation d'une zone de fragilisation dans ledit substrat donneur, de sorte à délimiter une deuxième couche active semi-conductrice (6),
- transfert de ladite deuxième couche active semi-conductrice (6) sur la structure intermédiaire, une deuxième couche électriquement isolante (5) étant à l'interface entre le substrat donneur et la structure intermédiaire et qui présente une épaisseur inférieure à celle de la première couche électriquement isolante,
- réalisation :
d'au moins un composant digital (11) dans la deuxième couche active semi-conductrice (6) à l'aplomb de la première couche intercalaire semi-conductrice (4), pour former une région de type FD-SOI, et
d'au moins un composant radiofréquence (12) à l'aplomb de la troisième couche électriquement isolante (7), pour former une région de type RF-SOI.

12. Procédé selon la revendication 10 ou la revendication 11, dans lequel le retrait local d'une portion de la première couche intercalaire semi-conductrice (4) et le dépôt d'une troisième couche électriquement isolante (7) dans la cavité sont réalisées après le transfert de la deuxième couche active semi-conductrice (6) sur la structure intermédiaire.

13. Procédé selon l'une des revendications 10 à 12, comprenant en outre la formation d'une couche de piégeage de charges (8) sur le substrat support (2), ladite couche de piégeage de charges étant agencée entre le substrat support (2) et la première couche électriquement isolante (3).

14. Procédé selon l'une des revendications 10 à 13, dans lequel le retrait local comprend le dépôt d'un masque par lithographie et la gravure de la première couche intercalaire semi-conductrice (4) au travers d'au moins une ouverture dudit masque.

15. Procédé selon l'une des revendications 10 à 14, comprenant en outre, avant le transfert de ladite deuxième couche active semi-conductrice (6) sur la structure intermédiaire, un traitement des surfaces libres de la première couche intercalaire semi-conductrice (4) et de la troisième couche électriquement isolante (7) pour en réduire la rugosité.

## Patentansprüche

1. Mehrschichtstruktur (1) vom Typ Halbleiter auf Isolator, die nacheinander von einer Rückseite zu einer Vorderseite der Struktur umfasst:
- ein halbleitendes Trägersubstrat (2) mit einem spezifischen elektrischen Widerstand zwischen 500 Ω.cm und 30 kΩ.cm,
- eine erste elektrisch isolierende Schicht (3),
- eine Zwischenschicht (1),
- eine zweite elektrisch isolierende Schicht (5), die dünner als die erste elektrisch isolierende Schicht (3) ist,
- eine aktive halbleitende Schicht (6)
- mindestens eine Region vom Typ FD-SOI, in der die Zwischenschicht (1) eine halbleitende Schicht (4) ist,
- mindestens eine Region vom Typ RF-SOI, die an die Region vom Typ FD-SOI angrenzt, in der die Zwischenschicht (1) eine dritte elektrisch isolierende Schicht (7) ist, wobei die Region vom Typ RF-SOI mindestens eine Hochfrequenzkomponente lotrecht zur dritten elektrisch isolierenden Schicht (7) umfasst.

2. Struktur (1) nach Anspruch 1, wobei die Summe der Dicken der ersten elektrisch isolierenden Schicht (3), der zweiten elektrisch isolierenden Schicht (5) und der dritten elektrisch isolierenden Schicht (7) zwischen 50 nm und 1500 nm liegt.

3. Struktur (1) nach Anspruch 1 oder Anspruch 2, die ferner eine zwischen dem Trägersubstrat (2) und der ersten elektrisch isolierenden Schicht (3) eingerichtete Ladungstrappingschicht (8) umfasst.

4. Struktur (1) nach Anspruch 3, wobei die Ladungstrappingschicht (8) aus polykristallinem Silizium oder porösem Silizium besteht.

5. Struktur (1) nach einem der Ansprüche 1 bis 4, wobei die halbleitende Zwischenschicht (4) aus kristallinem Material oder polykristallinem Material oder aus amorphem Material besteht.

6. Struktur (1) nach einem der vorhergehenden Ansprüche, wobei mindestens eine von der ersten elektrisch isolierenden Schicht (3), der zweiten elektrisch isolierenden Schicht (5) und der dritten elektrisch isolierende Schicht (7) eine Siliziumoxidschicht ist.

7. Struktur (1) nach einem der vorhergehenden Ansprüche, wobei die erste elektrisch isolierende Schicht (3) eine Dicke zwischen 20 nm und 1000 nm aufweist.

8. Struktur (1) nach einem der vorhergehenden Ansprüche, wobei die zweite elektrisch isolierende Schicht (5) eine Dicke zwischen 10 nm und 100 nm aufweist.

9. Struktur (1) nach einem der vorhergehenden Ansprüche, wobei die aktive halbleitende Schicht (6) eine Dicke zwischen 3 nm und 30 nm aufweist.

10. Verfahren zur Herstellung einer Mehrschichtstruktur (1) vom Typ Halbleiter auf Isolator, das die folgenden Schritte umfasst:
- Bereitstellen eines ersten Donorsubstrats,
- Bilden einer Schwächungszone im ersten Donorsubstrat, sodass eine erste halbleitende Zwischenschicht (4) begrenzt wird,
- Übertragen der ersten halbleitenden Zwischenschicht (4) auf ein halbleitendes Trägersubstrat (2), wobei eine erste elektrisch isolierende Schicht (3) an der Schnittstelle zwischen dem Donorsubstrat und dem Trägersubstrat (2) ist, sodass eine Zwischenstruktur gebildet wird, die das Trägersubstrat (2), die erste elektrisch isolierende Schicht (3) und die übertragene erste halbleitende Zwischenschicht (4) umfasst,
- lokales Entfernen eines Abschnitts der ersten halbleitenden Zwischenschicht (4) bis zur ersten elektrisch isolierenden Schicht (3) zwecks Bildung eines Hohlraums,
- Ablagern einer elektrisch isolierenden Schicht, bezeichnet als dritte elektrisch isolierende Schicht (7), im Hohlraum,
- Bereitstellen eines zweiten Donorsubstrats,
- Bilden einer Schwächungszone im zweiten Donorsubstrat, sodass eine zweite halbleitenden aktive Schicht (6) begrenzt wird,
- Übertragen der zweiten aktiven halbleitenden Schicht (6) auf die Zwischenstruktur, wobei eine zweite elektrisch isolierende Schicht (5) an der Schnittstelle zwischen dem zweiten Donorsubstrat und der Struktur ist und
eine geringere Dicke als die erste elektrisch isolierende Schicht aufweist,
- Herstellen:
mindestens einer digitalen Komponente (11) in der zweiten aktiven halbleitenden Schicht (6) lotrecht zur ersten halbleitenden Zwischenschicht (4), um eine Region vom Typ FD-SOI zu bilden, und mindestens einer Hochfrequenzkomponente (12) lotrecht zur dritten elektrisch isolierenden Schicht (7), um eine Region vom Typ RF-SOI zu bilden.

11. Verfahren zur Herstellung einer Mehrschichtstruktur (1) vom Typ Halbleiter auf Isolator, das die folgenden Schritte umfasst:
- Bilden einer Zwischenstruktur durch Ablagern einer ersten halbleitenden Zwischenschicht (4) auf einem Trägersubstrat (2), das von einer ersten elektrisch isolierenden Schicht (3) bedeckt ist,
- lokales Entfernen eines Abschnitts der ersten halbleitenden Zwischenschicht (4) bis zur ersten elektrisch isolierenden Schicht (3) zwecks Bildung eines Hohlraums,
- Ablagern einer elektrisch isolierenden Schicht, bezeichnet als dritte elektrisch isolierende Schicht (7), im Hohlraum,
- Bereitstellen eines Donorsubstrats,
- Bilden einer Schwächungszone im Donorsubstrat, sodass eine zweite halbleitende aktive Schicht (6) begrenzt wird,
- Übertragen der zweiten aktiven halbleitenden Schicht (6) auf die Zwischenstruktur, wobei eine zweite elektrisch isolierende Schicht (5) an der Schnittstelle zwischen dem Donorsubstrat und der Zwischenstruktur ist und
eine geringere Dicke als die erste elektrisch isolierende Schicht aufweist,
- Herstellen:
mindestens einer digitalen Komponente (11) in der zweiten aktiven halbleitenden Schicht (6) lotrecht zur ersten halbleitenden Zwischenschicht (4), um eine Region vom Typ FD-SOI zu bilden, und mindestens einer Hochfrequenzkomponente (12) lotrecht zur dritten elektrisch isolierenden Schicht (7), um eine Region vom Typ RF-SOI zu bilden.

12. Verfahren nach Anspruch 10 oder Anspruch 11, wobei die lokale Entfernung eines Abschnitts der ersten halbleitenden Zwischenschicht (4) und die Ablagerung einer dritten elektrisch isolierenden Schicht (7) im Hohlraum nach der Übertragung der zweiten aktiven halbleitenden Schicht (6) auf die Zwischenstruktur erfolgt.

13. Verfahren nach einem der Ansprüche 10 bis 12, das ferner die Bildung einer Ladungstrappingschicht (8) auf dem Trägersubstrat (2) umfasst, wobei die Ladungstrappingschicht zwischen dem Trägersubstrat (2) und der ersten elektrisch isolierenden Schicht (3) eingerichtet ist.

14. Verfahren nach einem der Ansprüche 10 bis 13, wobei die lokale Entfernung das Ablagern einer Maske durch Lithographie und das Ätzen der ersten halbleitenden Zwischenschicht (4) durch mindestens eine Öffnung in der Maske umfasst.

15. Verfahren nach einem der Ansprüche 10 bis 14, das ferner vor der Übertragung der zweiten aktiven halbleitenden Schicht (6) auf die Zwischenstruktur eine Behandlung der freien Oberflächen der ersten halbleitenden Zwischenschicht (4) und der dritten elektrisch isolierenden Schicht (7) zur Verringerung der Rauheit umfasst.

## Claims

1. A multilayer structure (1) of the semiconductor-on-insulator type, comprising in succession from a rear face to a front face of the structure:
- a semiconductor support substrate (2) having an electrical resistivity of between 500 Ω.cm and 30 kΩ.cm,
- a first electrically insulating layer (3),
- an intermediate layer (I),
- a second electrically insulating layer (5), which has a thickness less than that of the first electrically insulating layer (3),
- a semiconductor active layer (6),
- at least one FD-SOI type region, in which the interlayer (I) is a semiconductor layer (4),
- at least one RF-SOI type region, adjacent to the FD-SOI type region, in which the interlayer (I) is a third electrically insulating layer (7), said RF-SOI type region comprising at least one radio frequency component plumb with the third electrically insulating layer (7).

2. The structure (1) of claim 1, wherein the sum of the thicknesses of the first electrically insulating layer (3), the second electrically insulating layer (5), and the third electrically insulating layer (7) is between 50 nm and 1500 nm.

3. The structure (1) according to claim 1 or claim 2, further comprising a charge trapping layer (8) arranged between the support substrate (2) and the first electrically insulating layer (3).

4. The structure (1) of claim 3, wherein the charge trapping layer (8) is made of polycrystalline silicon or porous silicon.

5. The structure (1) according to any of claims 1 to 4, wherein the semiconductor interlayer (4) is made of crystalline or polycrystalline material or amorphous material.

6. The structure (1) according to any of the preceding claims, wherein at least one of the first electrically insulating layer (3), the second electrically insulating layer (5) and the third electrically insulating layer (7) is a silicon oxide layer.

7. The structure (1) according to any of the preceding claims, wherein the first electrically insulating layer (3) has a thickness between 20 nm and 1000 nm.

8. The structure (1) according to any of the preceding claims, wherein the second electrically insulating layer (5) has a thickness between 10 nm and 100 nm.

9. The structure (1) according to any of the preceding claims, wherein the semiconductor active layer (6) has a thickness between 3 nm and 30 nm.

10. A method of manufacturing a multilayer structure (1) of the semiconductor-on-insulator type, comprising the following steps:
- providing a first donor substrate,
- forming an embrittlement region in said first donor substrate, so as to delimit a first semiconductor interlayer (4),
- transferring said first semiconductor interlayer (4) onto a semiconductor support substrate (2), a first electrically insulating layer (3) being at the interface between the donor substrate and the carrier substrate (2) so as to form an intermediate structure comprising the carrier substrate (2), the first electrically insulating layer (3), and the transferred first semiconductor spacer layer (4)
- local removal of a portion of the first semiconductor interlayer (4) to the first electrically insulating layer (3) to form a cavity,
- deposition of an electrically insulating layer, so-called third electrically insulating layer (7), in the cavity,
- provision of a second donor substrate,
- forming an embrittlement zone in said second donor substrate, so as to delimit a second semiconductor active layer (6),
- transferring said second semiconductor active layer (6) onto the intermediate structure, a second electrically insulating layer (5) being at the interface between the second donor substrate and the intermediate structure and presenting a thickness lower than the thickness of the first electrically insulating layer,
- making :
at least one digital component (11) in the second semiconductor active layer (6) plumb with the first semiconductor interlayer (4), to form an FD-SOI region, and
at least one radio frequency component (12) in the third electrically insulating layer (7) to form an RF-SOI region.

11. A method of manufacturing a multilayer structure (1) of the semiconductor-on-insulator type, comprising the following steps:
- forming an intermediate structure by depositing a first semiconductor interlayer (4) on a support substrate (2) covered by a first electrically insulating layer (3),
- locally removing a portion of the first semiconductor interlayer (4) down to the first electrically insulating layer (3) to form a cavity,
- depositing an electrically insulating layer, so-called third electrically insulating layer (7) depositing an electrically insulating layer, so-called third electrically insulating layer (7), in the cavity,
- providing a donor substrate,
- forming an embrittlement zone in said donor substrate, so as to delimit a second semiconductor active layer (6),
- transferring said second semiconductor active layer (6) onto the intermediate structure, a second electrically insulating layer (5) being at the interface between the donor substrate and the intermediate structure and presenting a thickness less than the thickness of the first electrically insulating layer,
- making :
at least one digital component (11) in the second semiconductor active layer (6) plumb with the first semiconductor interlayer (4), to form an FD-SOI type region, and
at least one radio frequency component (12) plumb with the third electrically insulating layer (7) to form an RF-SOI type region.

12. The method according to claim 10 or claim 11, wherein local removal of a portion of the first semiconductor interlayer (4) and deposition of a third electrically insulating layer (7) in the cavity are performed after transfer of the second semiconductor active layer (6) onto the intermediate structure.

13. The method according to any of claims 10 to 12, further comprising forming a charge trapping layer (8) on the support substrate (2), said charge trapping layer being arranged between the support substrate (2) and the first electrically insulating layer (3).

14. The method according to any of claims 10 to 13, wherein the local removal comprises lithographically depositing a mask and etching the first semiconductor interlayer (4) through at least one opening of said mask.

15. The method according to any of claims 10 to 14, further comprising, prior to the transfer of said second semiconductor active layer (6) onto the intermediate structure, a treatment of the free surfaces of the first semiconductor interlayer (4) and the third electrically insulating layer (7) to reduce their roughness.
